# EUROPEAN PATENT APPLICATION

(11) **EP 3 301 714 A1**
(43) Date of publication of application: **04.04.2018**
(21) Application number: 16204143.8
(22) Date of filing: 14.12.2016
(51) Int. Cl.: H01L 23/538

(54) **CIRCUIT BOARD WITH MULTIPLE DENSITY REGIONS**

(30) Priority: 30.09.2016 US 201615282386
(71) Applicant: Advanced Micro Devices, Inc., Sunnyvale, CA 94088 (US)
(72) Inventor: McLELLAN, Robert, Austin, TX Texas 78737 (US)
(74) Representative: Eve, Rosemary Margaret

(57) **Abstract**

Various circuit boards and methods of fabricating and using the same are disclosed. In one aspect, a system is provided that includes a circuit board that has a first region including a first group of circuit structures adapted to interconnect two or more semiconductor chips and arranged according to a first design rule of a first density. A second region is external to the first region and includes a second group of circuit structures arranged according to a second design rule of a second density lower than the first density.

## Description

### BACKGROUND OF THE INVENTION

### 1. Field of the Invention

This invention relates generally to semiconductor processing, and more particularly to circuit boards with chip-to-chip interconnects and methods of making the same.

### 2. Description of the Related Art

A conventional type of multi-chip module includes two semiconductor chips mounted side-by-side on a carrier substrate or in some cases on an interposer that is, in-turn, mounted on a carrier substrate. The semiconductor chips are flip-chip mounted to the carrier substrate and interconnected thereto by respective pluralities of solder joints. The carrier substrate is provided with plural electrical pathways to provide input/output pathways for the semiconductor chips both for inter-chip power, ground and signal propagation as well as input/output from the interposer itself. The semiconductor chips include respective underfill material layers to lessen the effects of differential thermal expansion due to differences in the coefficients of thermal expansion of the chips, the interposer and the solder joints.

Chip geometries have continually fallen over the past few years. However the shrinkage in chip sizes has been accompanied by an attendant increase in the number of input/outputs for a given chip. This has led to a need to greatly increase the number of chip-to-chip interconnects for multi-chip modules. One conventional technique to address the need for increased chip-to-chip interconnects involves using a high density design rule across all regions of a package substrate. This can be a costly solution due to manufacturing complexity and yield issues. Another conventional solution uses 3D stacking of chips and through-silicon-vias for interconnections. This too is complex and costly. Finally, some conventional designs uses embedded interconnect bridges (EMIB). These are typically silicon bridge chips (but occasionally organic chiplets with top side only input/outputs) that are embedded in the upper reaches of the package substrate. The silicon is costly and alignment of the EMIB is logistically complex.

The present invention is directed to overcoming or reducing the effects of one or more of the foregoing disadvantages.

### SUMMARY OF THE INVENTION

In accordance with one aspect of the present invention, a system is provided that includes a circuit board that has a first region including a first group of circuit structures adapted to interconnect two or more semiconductor chips and arranged according to a first design rule of a first density. A second region is external to the first region and includes a second group of circuit structures arranged according to a second design rule of a second density lower than the first density.

In accordance with another aspect of the present invention, a method of manufacturing a circuit board is provided. The method includes fabricating a first region including a first group of circuit structures adapted to interconnect two or more semiconductor chips and arranged according to a first design rule of a first density. A second region is fabricated external to the first region and includes a second group of circuit structures arranged according to a second design rule of a second density lower than the first density.

In accordance with another aspect of the present invention, a method of manufacturing is provided that includes mounting a first semiconductor chip on a circuit board. The circuit board has a first region including a first group of circuit structures adapted to interconnect two or more semiconductor chips and is arranged according to a first design rule of a first density. The circuit board includes a second region external to the first region and including a second group of circuit structures arranged according to a second design rule of a second density lower than the first density. A second semiconductor chip is mounted on the circuit board. The first semiconductor chip is interconnected to the second semiconductor chip with the circuit structures of the first region.

### BRIEF DESCRIPTION OF THE DRAWINGS

The foregoing and other advantages of the invention will become apparent upon reading the following detailed description and upon reference to the drawings in which:
FIG. 1 is a pictorial view of an exemplary embodiment of a semiconductor chip device that includes a circuit board and one or more semiconductor chips;
FIG. 2 is a plan view of the semiconductor chip device depicted in FIG. 1;
FIG. 3 is a sectional view of FIG. 2 taken at section 3-3;
FIG. 4 is a sectional view of FIG. 2 taken at section 4-4;
FIG. 5 is a plan view of a few exemplary conductor lines in different density circuit regions;
FIG. 6 is a sectional view depicting initial exemplary build-up layer fabrication of an exemplary circuit board;
FIG. 7 is a sectional view like FIG. 6 but depicting exemplary masking and photolithography exposure;
FIG. 8 is a sectional view like FIG. 7 but depicting exemplary material removal to pattern conductor structures;
FIG. 9 is a sectional view like FIG. 7 but depicting alternate exemplary photolithography masking exposure;
FIG. 10 is a sectional view like FIG. 9 but depicting a second photolithography masking and exposure process;
FIG. 11 is a sectional view like FIG. 6 but depicting exemplary build-up layer and via hole fabrication;
FIG. 12 is a sectional view like FIG. 11 but depicting exemplary conductive via formation;
FIG. 13 is a sectional view like FIG. 12 but depicting exemplary solder resist layer fabrication;
FIG. 14 is a pictorial view of an alternate exemplary circuit board fabrication process; and
FIG. 15 is a pictorial view like FIG. 14 but depicting additional masking and processing.

### DETAILED DESCRIPTION OF SPECIFIC EMBODIMENTS

Circuit boards, such as package substrates, with multiple circuit density regions are disclosed. An exemplary circuit board may be fabricated with a region of high circuit density and using a high density design rule and another region of lower circuit density and using a lower density design rule. The high density circuit region may be suitable for chip-to-chip interconnections where high density and bandwidth are desirable. However, the entirety of the circuit board need not incur the costs of high density processing. Additional details will now be disclosed.

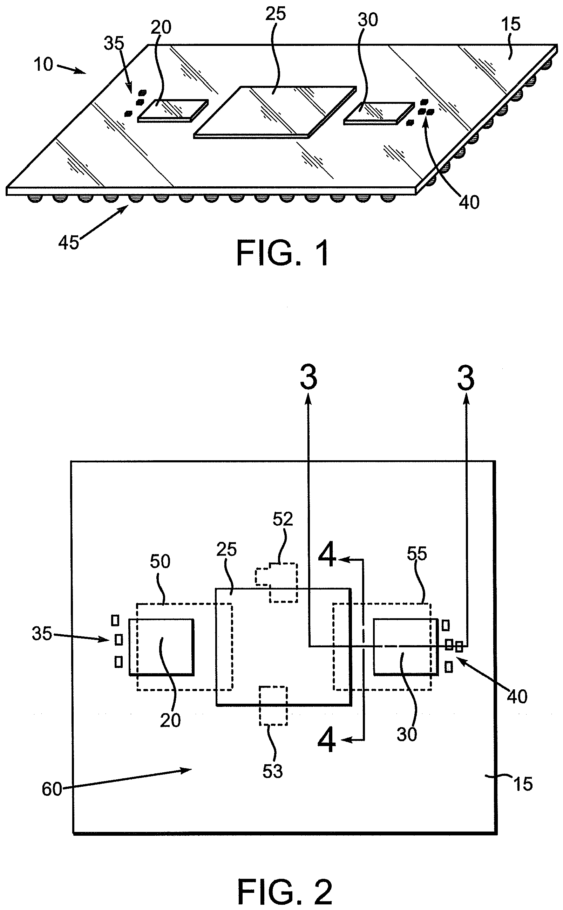

In the drawings described below, reference numerals are generally repeated where identical elements appear in more than one figure. Turning now to the drawings, and in particular to FIGS. 1 and 2, therein is depicted an exemplary embodiment of a semiconductor chip device (or a system) 10 that may include a circuit board 15 and multiple semiconductor chips 20, 25 and 30 mounted on the circuit board 15. In this illustrative embodiment, there are three semiconductor chips 20, 25 and 30 positioned on the circuit board 15. However, the number and spatial arrangement of the semiconductor chips 20, 25 and 30 may take on a great variety of configurations. Similarly, the circuit board 15 may be populated with plural surface components, groups of which are collectively labeled 35 and 40, respectively. The surface components 35 and 40 may be capacitors, inductors, resistors, or other types of components, and may number more or less than what is shown. The circuit board 15 may be a package substrate, a system board, or other type of circuit board as desired. To interface electrically with some other electronic components, such as a computing device or other electronic device (not shown), the circuit board 50 may be provided with plural input/outputs, which in this illustrative embodiment are depicted as a solder ball grid array 45. However, other types of interconnect structures, such as pins, lands or other type of interconnect structures may be used as well.

The semiconductor chips 20, 25 and 30 may be any of a myriad of different types of circuit devices used in electronics, such as, for example, microprocessors, graphics processors, combined microprocessor/graphics processors, application specific integrated circuits, memory devices, active optical devices, such as lasers, passive optical devices or the like, interposers, and may be single or multi-core or even stacked laterally with additional dice.

As described in more detail below, the circuit board 15 may be fabricated using multiple design rules: one or more design rules for higher density circuit structures and one or more design rules for lower density circuit structures. For example, and as depicted in FIG. 2, the circuit board 15 may be fabricated using a high density design rule(s) in high density circuit regions 50, 52, 53 and 55, and a lower density design rule in the low density circuit region 60 external to the high density circuit regions 50, 52, 53 and 55. The high density design rules are used to create in the high density circuit regions 50, 52, 53 and 55 larger numbers of electrical pathways than would ordinarily be possible using a lower density design rule for the entirety of the circuit board 15. The high density circuit regions 50, 52, 53 and 55 may be used for a variety of purposes. For example, the high density circuit regions 50 may be used to provide large numbers of electrical pathways between the semiconductor chip 25 and the semiconductor chip 20 and the high density circuit region 55 may be similarly used to provide large numbers of electrical pathways between the semiconductor chip 25 and the semiconductor chip 30. The high density circuit regions 52 and 53 may serve the same general purpose or other purpose. Furthermore, the utilization of high density design rules to create the high density circuit regions 50, 52, 53 and 55 but not the low density circuit region 60 has the potential to increase the yield of the circuit board 15 and others like it during the manufacturing process. It should be understood that the high density circuit regions 50, 52, 53 and 55 may number other than four, be of various footprints and be spatially arranged in a huge variety of ways on the circuit board 15 depending upon the electronic requirements of the circuit board 15, the number of semiconductor chips mounted thereon and other design considerations.

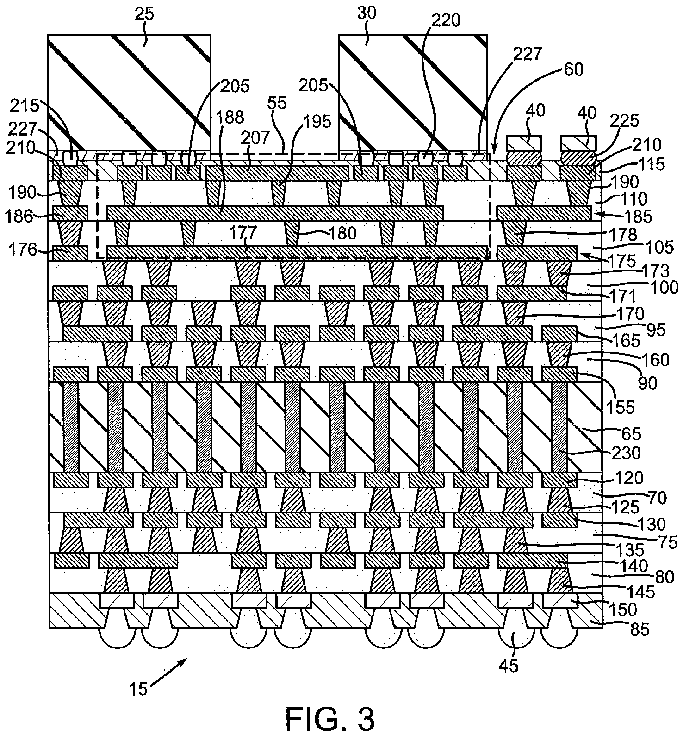

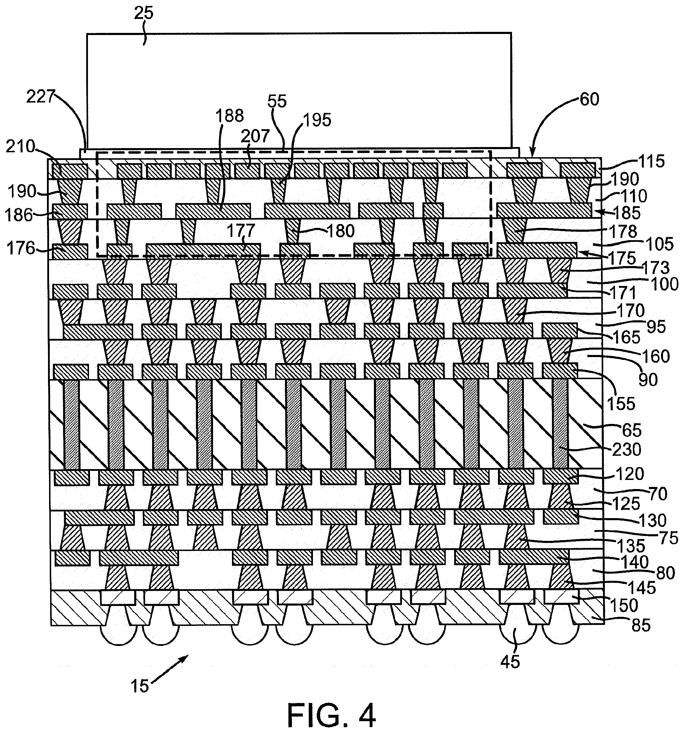

Additional details of the circuit board 15 may be understood by referring now also to FIG. 3, which is a sectional view of FIG. 2 taken at section 3-3 and to FIG. 4, which is a sectional view of FIG. 2 taken at section 4-4. It should be noted that section 3-3 extends through a portion of the circuit board 15 and includes part of the semiconductor chip 25, the semiconductor chip 30 and two of the components 40. It should be noted that section 4-4 extends through a portion of the circuit board 15, but the semiconductor chip 30 is not visible and the semiconductor chip 25, while visible, is not shown in section. The circuit board 15 may be a package substrate or other type of printed circuit board as described elsewhere herein. Monolithic or build-up structures may be used. If a build-up design is used, the circuit board 15 may consist of a central core 65 upon which one or more build-up layers are formed and below which an additional one or more build-up layers are formed. The core 60 itself may consist of a stack of one or more layers. The number of layers in the circuit board 15 can vary from four to sixteen or more, although less than four may be used. So-called "coreless" designs may be used as well. The layers of the circuit board 15 consist of an insulating material, such as various well-known epoxies or other resins, interspersed with metal interconnects. A multi-layer configuration other than build-up could be used. Optionally, the circuit board 15 may be composed of well-known ceramics or other materials suitable for package substrates or other printed circuit boards.

In this illustrative embodiment, the circuit board 15 may be a build-up design that includes the core 65, three lower build-up layers 70, 75 and 80 and a bottom solder resist layer 85 and five upper build-up layers 90, 95, 100, 105 and 110 and a top solder resist layer 115. As note above, the number of build-up layers 70, 75, 80, 90, 95, 100, 105 and 110 may be varied and symmetric, that is, of the same number on either side of the core 65 (or even if coreless) or asymmetric as depicted. The core 65 may be monolithic or a laminate of two or more layers as desired. The core 65 may be constructed of one or more layers of glass filled epoxy or other polymeric materials. The build-up layers 70, 75, 80, 90, 95, 100, 105 and 110 may be composed of well-known polymeric materials, such as, GX13 supplied by Ajinomoto, Ltd. or other types of polymers. The solder resist layers 85 and 115 may be fabricated from a variety of materials suitable for solder mask fabrication, such as, for example, PSR-4000 AUS703 manufactured by Taiyo Ink Mfg. Co., Ltd. or SR7000 manufactured by Hitachi Chemical Co., Ltd. The build-up layer 70 may include a conductor layer 120 that includes plural conductor structures, such as lines, via lands, pads, etc. In addition, the build-up layer 70 includes plural conductive vias 125 that are formed on the structures of the conductor layer 120. The conductor layer 120 and the conductive vias 125 may be composed of copper, aluminum, gold, silver, palladium, platinum or other conductors or combinations of these. The same is true for the conductor layers and vias in the other build-up layers 75, 80, 90, 95, 100, 105 and 110. The build-up layer 75 similarly includes a conductor layer 130 and plural conductive vias 135 and the build-up layer 80 also includes a conductor layer 140 and plural conductive vias 145. Embedded within the solder resist layer 85 is a bottommost conductor layer 150, which may consist of plural ball pads or other conductor structures depending upon the type of I/O structures used and thus in this case the solder balls 45. The conductor layer 150 may be composed of copper, aluminum, gold, silver, palladium, platinum or other conductors. If solder contamination is a technical concern then the conductor layer 150 may be constructed with barrier materials, such as nickel or nickel-vanadium or others. Any of the conductor structures disclosed herein as possibly being composed of solder may be composed of various types of solders, such as lead-free or lead-based solders. Examples of suitable lead-free solders include tin-silver (about 97.3% Sn 2.7% Ag), tin-copper (about 99% Sn 1% Cu), tin-silver-copper (about 96.5% Sn 3% Ag 0.5% Cu) or the like. Examples of lead-based solders include tin-lead solders at or near eutectic proportions or the like.

Turning to the opposite side of the core 65, the build-up layer 90 may include a conductor layer 155 composed of plural conductor structures of the type described above as well as plural conductive vias 160, again of the type described above, in conjunction with the lower build-up layers 70, 75 etc. The build-up layer 95 similarly may include a conductor layer 165 and plural conductive vias 170, and the build-up layer 100 may include a conductor layer 171 and conductive vias 173. The high density circuit region 55 may have some lateral extent (or multiple lateral extents if of other than a rectangular footprint) and some vertical extent that may encompass one or more of the build-up layers and the solder resist layer 115. Those circuit structures in the high density circuit region 55 may be constructed using a high density design rule and those circuit structures in the low density circuit region 60 may be constructed using a lower density design rule. In this illustrative embodiment, the high density circuit region 55 may extend vertically to encompass a portion of the build-up layer 105, the build-up layer 110 and the solder resist layer 115. Thus, the build-up layer 105 may include a conductor layer 175 that has plural low density circuit region conductor structures or traces 176 in the low density circuit region 60 and plural high density circuit region conductor structures or traces 177 in the high density circuit region 55. Only one trace 177 is visible in FIG. 3, but as is evident in FIG. 4, there may be large numbers of such traces 177, and indeed many more than what is depicted in FIG. 4., to provide interconnects between the semiconductor chips 25 and 30. In addition, the build-up layer 105 includes plural low density circuit region conductive vias 178 in the low density circuit region 60 and plural high density circuit region conductive vias 180 in the high density circuit region 55. The build-up layer 110 may similarly include a conductor layer 185 with plural low density circuit region conductors 186 and plural high density circuit region conductors 188, and plural low density circuit region conductive vias 190 and plural high density circuit region conductive vias 195. The same is true with regard to the solder resist layer 115 where the input output pads 205 (not visible in FIG. 4) and other conductor traces 207 within the high density circuit region 55 may be fabricated using a higher density design rule and thus with smaller geometries and spacing than the input output pads or traces 210 outside of the high density circuit region 55 and in the low density circuit region 60. Note that the semiconductor chip 25 may interface electrically with the pads 205 and 210 by way of the illustrated solder bumps 215 by way of conductive pillars or other interconnect structures as desired. The semiconductor chip 30 may similarly interface electrically with some of the pads 205 by way of solder bumps 220 or other interconnect structures just described in conjunction with the chip 225. The surface components 40 may be electrically connected to the pads 210 by way of solder structures 225. Underfills 227 may be positioned between the semiconductor chips 25 and 30 and the circuit board 15 to lessen the effects of stresses induced by differences in coefficients of thermal expansion of the chips 25 and 30 and the circuit board 15. The underfills 227 may be composed of well-known epoxy materials, such as epoxy resin with or without silica fillers and phenol resins or the like. Two examples are types 8437-2 and 2BD available from Namics.

The electrical pathways between the upper build-up layers 90, 95 etc. and the lower build-up layers 70, 75 etc. may be provided through the core 65 by way of plural through vias 230, which may be composed of same types of materials disclosed elsewhere herein in conjunction with conductor layers and vias.

In this illustrative embodiment, the lower build-up layers 70, 75 and 80 and the solder resist layer 85 may all be patterned using a given design rule with given nominal geometries for lines and spaces and the same is true with regard to the upper build-up layers 90, 95 and 100. In addition, and as described in more detail below, those circuit structures in the build-up layers 105, 110 and the solder resist layer 115 outside of the high density circuit region 55 may also be constructed using the design rules of a given geometry, such as those used for the lower build-up layers, while those structures within the high density circuit region 55 may be constructed using a design rule or rules that have a smaller nominal geometry for lines and spaces and thus a higher density. The nomenclature for a typical design rule is *x* µm/*x* µm (e.g., 10 µm/10 µm) where the numerator indicates the minimum width for a conductor line and the denominator indicates the minimum width for a space between adjacent conductor lines or other conductor structures. Here the units are microns, but the principle applies equally for other units. A *x* µm/*x* µm (lines and spaces) is a typical design rule definition, but some other definition could be used to still achieve a technical goal of patterning a high density circuit region 55 and a low density circuit region 60 using design rules of different densities.

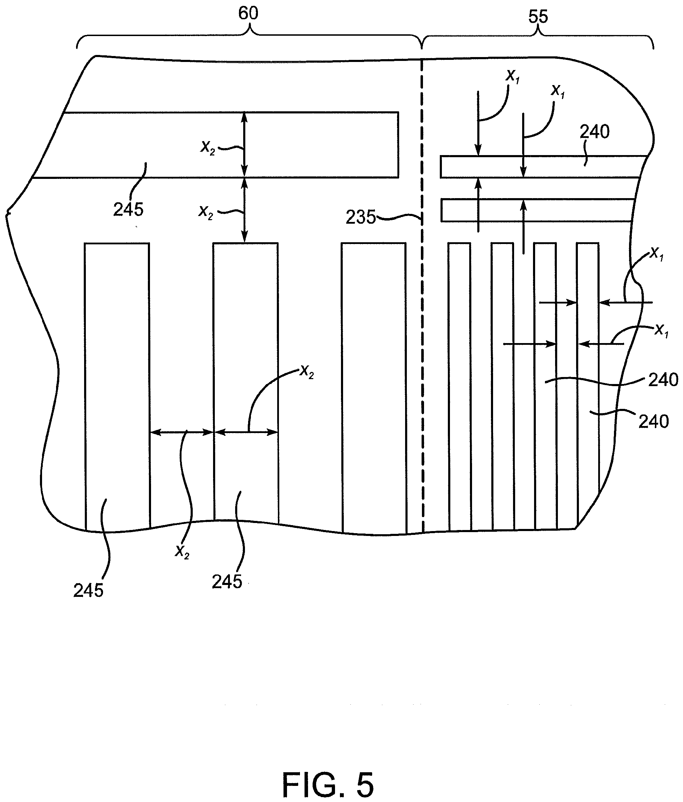

Fig. 5 is a plan view of some exemplary conductor lines positioned in the high density circuit region 55 and the low density circuit region 60. The dashed line 235 denotes the border between the high density circuit region 55 and the low density circuit region 60. The lines 240 in the high density circuit region 55 may be constructed with a design rule *x₁* µm*lx₁* µm that yields some minimum width and spacing *x₁* while the lines 245 in the lower density circuit region 60 may be constructed with a design rule *x₂* µm/*x₂* µm that yields some minimum width and spacing *x₂* where *x₂* > *x₁*. For example, the design rule for the high density circuit region might be a 1.0 µm/1.0 µm and *x₁* = 1.0 µm while the design rule for the low density circuit region 60 might be 10 µm/10 µm and *x₂* = 10 µm. Of course, these numbers can vary depending on device requirements and prevailing manufacturing capabilities.

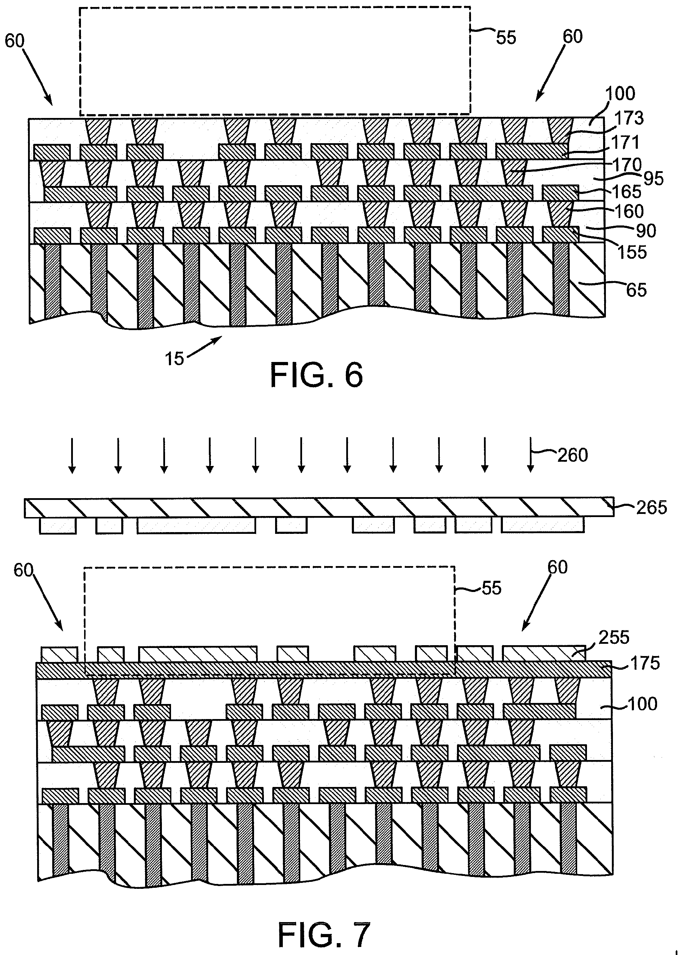

An exemplary method for fabricating the circuit board 15 using multiple design rules to create multiple density circuit regions may be understood by referring now to FIGS. 6, 7, 8, 9, 10, 11 and 12 and initially to FIG. 6. FIG. 6 is a sectional view like FIG. 4, but for simplicity of illustration the portion of the circuit board 15 below the core 65 is shown cut away. FIG. 6 also depicts the circuit board 15 following the fabrication of the build-up layers 90, 95 and 100 but prior to the fabrication of the build-up layer 105 shown in FIG. 4. It should be understood that the fabrication process for the circuit board 15 disclosed herein could be performed on a discrete board basis or en masse followed by singulation. The conductor layer 155 may be initially fabricated by applying a layer of conductor material using well-known techniques and thereafter appropriate masking and material removal such as by etching to establish the individual conductor structures of the conductor layer 155. Lift-off techniques could also be used. Thereafter, the build-up layer 90 may be applied over the conductor layer 155 by well-known techniques and then the via holes necessary to establish the conductive vias 160 may be formed using laser drilling, chemical etching, or by photolithography wherein the build-up layer 90 is provided with photo active compounds that enable openings to be formed using well-known photolithographic techniques. The same processes are applied to the build-up layers 95 and 100 to establish the conductor layers 165 and 171 and the vias 170 and 173.

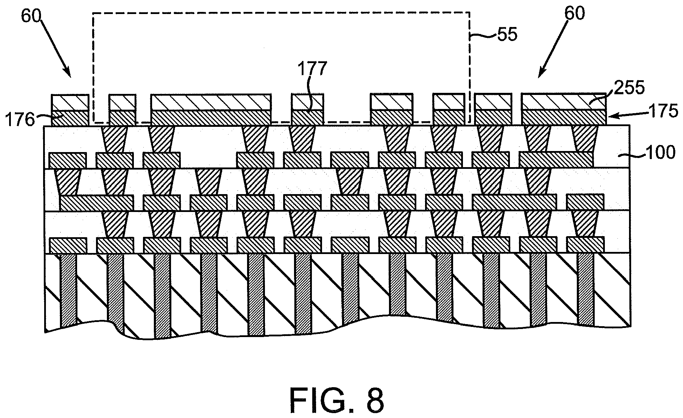

Next and as shown in FIG. 6, the conductor layer 175 may be formed on the build-up layer 100. The conductor layer 175 may be initially applied as a blanket layer as shown and thereafter patterned to establish the conductor structures for the conductor layer 175 both inside the high density circuit region 55 and in the lower density circuit region 60. This application of a low density design rule for the low density circuit region 60 and different higher density design rule for the high density circuit region 55 may be accomplished in a number of ways. For example, and as depicted in FIG. 7, a photomask 255 may be applied to the conductor layer 175 and photolithographically patterned appropriately using low density design rules *x₂* µm/*x₂* µm in the low density circuit region 60 and higher density design rule *x₁* µm/*x₁* µm in the high density circuit region 55. Exposure radiation 260 may be passed through an appropriate reticle 265 that is fabricated to create high density photoresist structures of the photomask 255 in the high density circuit region 55 but lower density masking structures in the lower density circuit regions 60 using a single exposure. After the exposure, a suitable developing process may be used to create the various high and low density structures of the photomask 255. Next, and as shown in FIG. 8, the photomask 255 is used to mask selected portions of the conductor layer 175 during a subsequent etch removal process that will leave the patterned conductor layer 175 with low density circuit region conductor structures 176 and high density circuit region conductor structures 177 as shown. A directional plasma etch using agents suitable for the material(s) of the conductor layer 175 may be used. Endpoint should be monitored to avoid excessive attack of the conductor structures in the underlying build-up layer 100. Following the etch process, the mask 255 may be removed by ashing, solvent stripping or combinations of the two. The mask strip should be tailored to avoid unacceptable damage to the build-up layer 100.

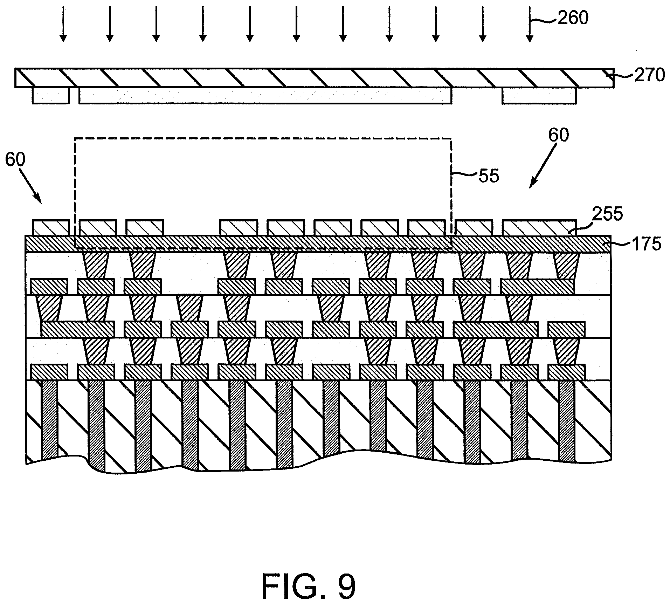

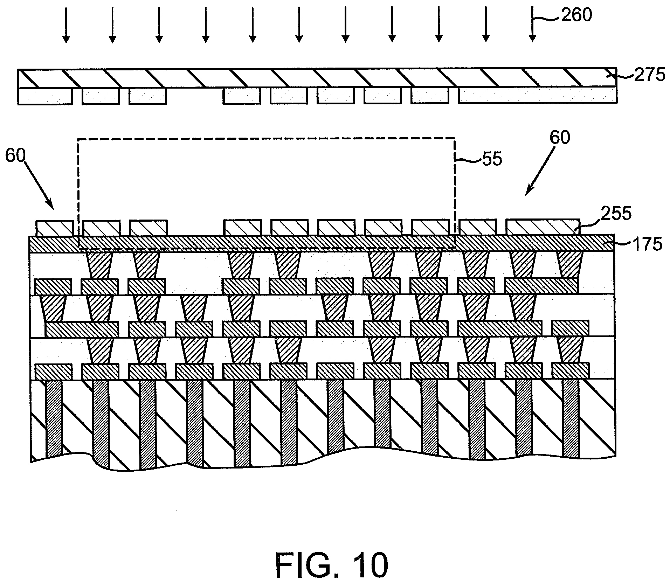

Optionally, and as shown in FIGS. 9 and 10, a dual reticle, dual exposure process may be used to establish the photomask 255 on the conductor layer 175 with the higher density features in the high density circuit region 55 and the lower density features in the lower density circuit region 60. First, and as shown in FIG. 9, a suitable reticle 270 may be used with exposure radiation 260 to expose the portions of the photomask 255 in the low density circuit region 60 (and following the low density design rule *x₂* µm/*x₂* µm) while fully masking the portion of the photomask 255 in the high density circuit region 55. Thereafter, and as shown in FIG. 10, a second reticle 275 may be used to fully mask the portions of the photomask 255 in the low density circuit region 60, but allow exposure radiation 260 to expose selected portions of the photo mask 255 in the high density circuit region (and following the high density design rule *x₁* µm/*x₁* µm). With the photomask 255 double exposed, once for the low density circuit region 60 and once for the high density circuit region 55, a suitable developing process may be used as described above to establish the various high density and low density features of the photomask 255. The etch removal of the selected portions of the conductor layer 175 may then proceed as described above in conjunction with FIG. 8.

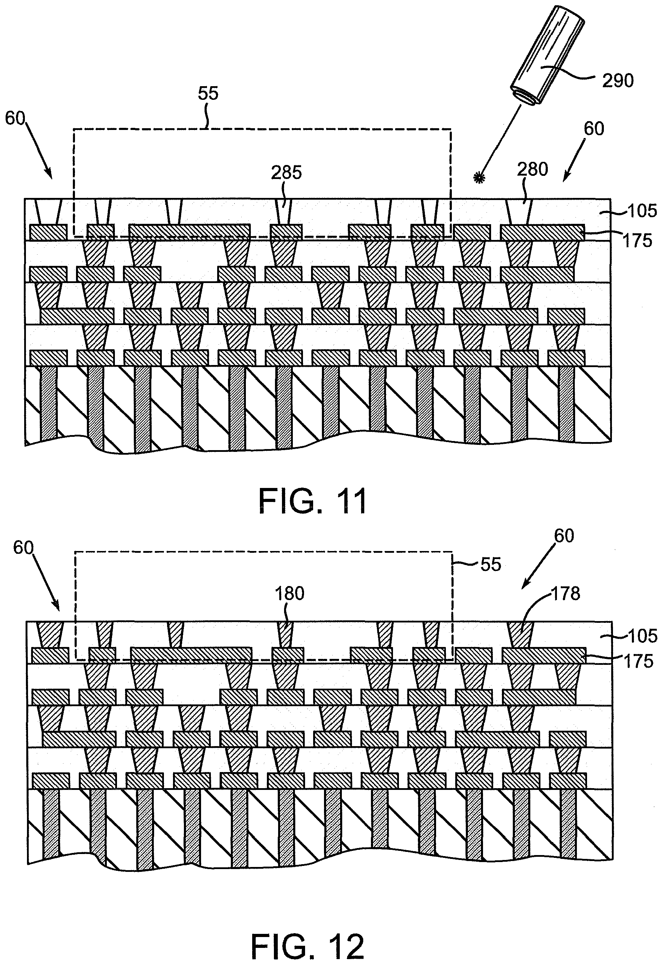

Next and as depicted in FIG. 11, the insulating material of the build-up layer 105 may be applied over the patterned conductor layer 175 using the techniques described above. Next, the conductive via holes 280 for the low density circuit region 60 and the via holes 285 for the high density circuit region 55 may be formed in the build-up layer 105. This may be performed in a variety of ways. Examples include, laser drilling by way of the laser source 290. The laser source 290 may be accurately controlled to drill lower density design rule via holes 280 in the low density circuit region 60 and smaller, and thus higher density design rule, vias 285 and the high density circuit region 55. Optionally, the via holes 280 and 285 may be constructed using photolithography where the build-up layer 105 is infused with photoactive compounds. This type of process will largely track the differential masking processes to establish the photomask 255 described above. Thus, a single reticle with a single exposure or a dual reticle duel exposure process may be used to establish the relatively larger via holes 280 and the relatively smaller via holes 285 in the same build-up layer 105. Of course, other via hole fabrication techniques could be used.

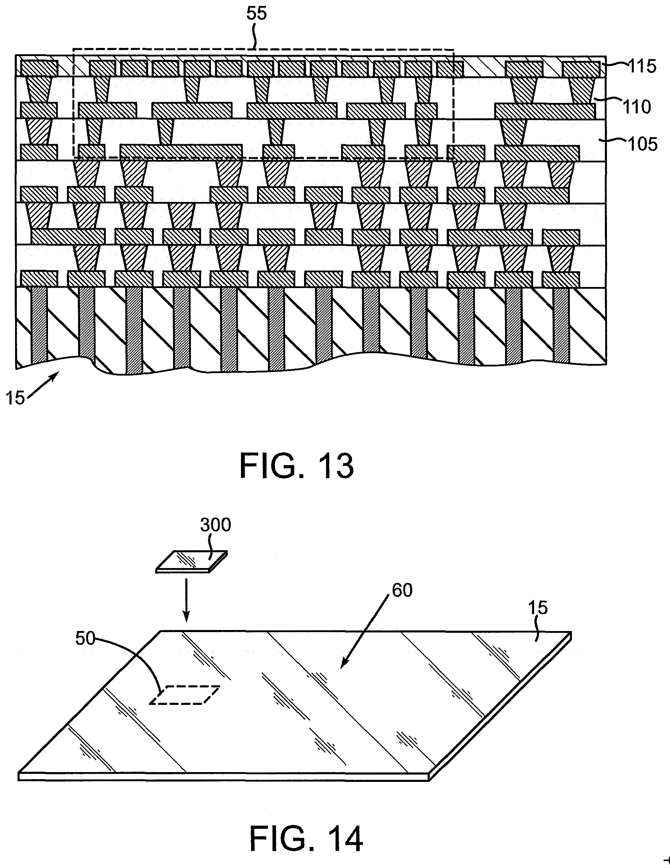

Next and as shown in FIG. 12, a suitable material application process may be used to establish the low density conductive vias 178 in the low density circuit region 60 and the high density conductive vias 180 in the high density circuit region 55. The conductive vias 178 and 180 may be formed by way of well-known plating or other deposition techniques. The foregoing process may be repeated on the circuit board 15 to fabricate the build-up layer 110 and the solder resist layer 115 as shown in FIG. 13. The solder resist layer 115 shown in FIGS. 3, 4 and 13 will typically include photoactive compounds to enable the straightforward photolithographic patterning thereof to establish openings for the various solder bumps 215 and 220 and the solder interconnect structures 225 shown in FIG. 3. Well-known chip mounting processes may then be used to mount the semiconductor chips 25 and 30 to the circuit board as shown in FIG. 3. The surface components 40 may be mounted and suitable reflow processes may be used to establish firm metallurgical connections between the chips 25 and 30 and the components 40 and the circuit board 15. The underfills 227 may be applied using well-known techniques.

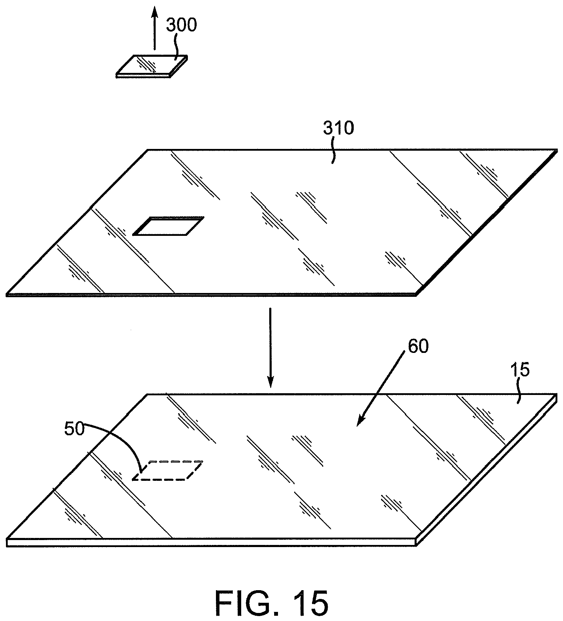

In the foregoing illustrative embodiment, various features such as conductor lines and vias, etc. in a high density circuit region, for example, the region 55, are concurrently patterned along with the circuit structures in a low density circuit region 60. This will typically result in the circuit structures in the high density circuit region 55 having smaller lines and spaces but perhaps the same vertical dimensions as the larger width and space structures in the low density circuit region 60. However, it may be possible to bifurcate the construction of the circuit structures in a high density circuit region from the construction of the circuit features in the low density circuit region and in this way permit the creation of circuit structures that not only have smaller lines and spaces in the x-y plane than the low density circuit regions but also perhaps smaller vertical dimensions as well, which again may facilitate shorter pathways and higher performance. An exemplary fabrication process using this technique will now be described in conjunction with FIGS. 14 and 15. Here the high density circuit region 50 and the low density circuit region 60 depicted in FIG. 2 will be used to illustrate the process. As shown in FIG. 14, the high density circuit region 50 of the circuit board 15 may be initially masked with a mask 300 composed of resist or even hard mask materials. This masking may occur at whatever level is determined to be the starting level for high density circuit processing. For example, this could occur at any level above, for example, the core 65 depicted in FIGS. 3 and 4. With the mask 300 in position, the low density circuit region 60 of the circuit board 15 may be subjected to the requisite processes to establish the low density conductor structures and the insulating portions of the various build-up layers. Thereafter and as shown in FIG. 15, the mask 300 may be removed using any of the mask removal techniques disclosed herein or other techniques that the mask 300 is a hard mask for example. Subsequently, another mask 310 may be applied to the circuit board 15 that fully masks the low density circuit region 60 but leaves the high density circuit region 50 exposed. Thereafter, and with the mask 310 in position, the high density circuit region 50 may be subjected to whatever material deposition patterning masking and other steps are necessary to create the various high density circuit build-up layers in the high density circuit region 55. Thereafter the photo mask 310 may be stripped using the techniques disclosed herein. Of course, the order of the application of the masks 300 and 310 the ultimate processing could reversed.

While the invention may be susceptible to various modifications and alternative forms, specific embodiments have been shown by way of example in the drawings and have been described in detail herein. However, it should be understood that the invention is not intended to be limited to the particular forms disclosed. Rather, the invention is to cover all modifications, equivalents and alternatives falling within the spirit and scope of the invention as defined by the following appended claims.

## Claims

1. A system, comprising:
a circuit board comprising a first region including a first group of circuit structures adapted to interconnect two or more semiconductor chips and being arranged according to a first design rule of a first density and a second region external to the first region and including a second group of circuit structures arranged according to a second design rule of a second density lower than the first density.

2. The system of claim 1, wherein the circuit board comprises a package substrate.

3. The system of claim 1, comprising a plurality of semiconductor chips on the second circuit board, wherein the first group of circuit structures create electrical pathways between the plurality of semiconductor chips.

4. The system of claim 1, comprising a plurality of semiconductor chips on the circuit board, wherein the second group of circuit structures create electrical pathways not between the plurality of semiconductor chips.

5. The system of claim 1, wherein the circuit board comprises plural build-up layers, the first region extending vertically to include at least one of the build-up layers.

6. The system of claim 5, wherein the circuit board comprises a core positioned between two of the build-up layers.

7. The system of claim 1, wherein the circuit board comprises a third region including a third group of circuit structures adapted to interconnect two or more semiconductor chips and being arranged according to the first design rule.

8. The system of claim 1, comprising a first semiconductor chip mounted on the circuit board and a second semiconductor chip mounted on the circuit board and interconnected to the first semiconductor chip by the circuit structures of the first region.

9. The system of claim 1, comprising plural input/outputs adapted to electrically connect the circuit board to another electronic device.

10. A method of manufacturing a circuit board, comprising:
fabricating a first region including a first group of circuit structures adapted to interconnect two or more semiconductor chips and being arranged according to a first design rule of a first density; and
fabricating a second region external to the first region and including a second group of circuit structures arranged according to a second design rule of a second density lower than the first density.

11. The method of claim 10, wherein the circuit board comprises a package substrate.

12. The method of claim 10, comprising fabricating plural build-up layers, the first region extending vertically to include at least one of the build-up layers.

13. A method of manufacturing, comprising:
mounting a first semiconductor chip on a circuit board, the circuit board having a first region including a first group of circuit structures adapted to interconnect two or more semiconductor chips and being arranged according to a first design rule of a first density and second region external to the first region and including a second group of circuit structures arranged according to a second design rule of a second density lower than the first density;
mounting a second semiconductor chip on the circuit board; and
interconnecting the first semiconductor chip to the second semiconductor chip with the circuit structures of the first region.

14. The method of claim 13, wherein the circuit board comprises a package substrate.

15. The method of claim 13, wherein the circuit board comprises plural build-up layers, the first region extending vertically to include at least one of the build-up layers.

16. The method of claim 15, wherein the circuit board comprises a core positioned between two of the build-up layers.

17. The method of claim 13, comprising a third region including a third group of circuit structures adapted to interconnect two or more semiconductor chips and being arranged according to the first design rule.

18. The method of claim 13, wherein the circuit board comprises plural input/outputs adapted to electrically connect the circuit board to another electronic device.
